# EUROPÄISCHE PATENTANMELDUNG

(11) **EP 1 120 906 A2**
(43) Veröffentlichungstag der Anmeldung: **01.08.2001**
(21) Anmeldenummer: 01100333.2
(22) Anmeldetag: 04.01.2001
(51) Int. Cl.: H03F 3/30

(54) **Schaltung zur Umsetzung eines Paars aus differenziellen Signalen in ein Eintaktsignal**

(30) Priorität: 24.01.2000 DE 10002850
(71) Anmelder: Infineon Technologies AG, 81669 München (DE)
(72) Erfinder: Kröbel, Hans-Eberhard, 81735 München (DE); Scholz, Markus, 81737 München (DE)
(74) Vertreter: Fischer, Volker, Dipl.-Ing.

(57) **Zusammenfassung**

Die vorliegende Erfindung betrifft eine Schaltung zur Umsetzung eines differenziellen Signalpaars in ein Eintaktsignal. Solche Schaltungen unterliegen Forderungen nach immer kürzeren Signallaufzeiten, geringerem Phasenrauschen und höherer Eingangsempfindlichkeit. Die vorliegende Erfindung löst diese Aufgabe dadurch, daß das Eingangsverstärker-Paar (Invl, Inv2) der Schaltung die erforderliche Mittenspannung durch Rückkopplung der Ein- und Ausgänge mittels Widerständen (R1, R2) erzeugt, wobei die Schaltung eingansseitig über Kondensatoren (C1, C2) entkoppelt ist.

## Beschreibung

Die vorliegende Erfindung bezieht sich auf eine Schaltung zur Umsetzung eines Paars aus differenziellen Signalen in ein Eintaktsignal, wie sie beispielsweise für eine Bipolar/CMOS-Umsetzung verwendet werden kann.

Bei der BICMOS-Technologie, welche eine Kombination von bipolaren Schaltelementen mit CMOS-Elementen aufweist, besteht häufig das Problem, analoge differenzielle Signale mit kleinem Pegel, beispielsweise ECL-Pegel mit mehreren 100mV Amplitude, in CMOS-Pegel umzuwandeln. CMOS-Pegel weisen typischerweise einen Spannungshub von der negativen bis zur positiven Versorgungsspannung des verwendeten CMOS-Schaltungsteils auf. An einer solchen Schnittstelle zwischen einer analogen und einer digitalen Funktionseinheit wird das differenzielle Analogsignal mit geringem Spannungspegel in ein Digitalsignal mit höherer Amplitude umgesetzt. Zu dieser Pegelanpassung werden Pegelversatzstufen eingesetzt, welche das von einem Ausgangsverstärker der Analogstufe verstärkte Analogsignal in den Umschaltbereich eines Eingangsverstärkers der Digitalstufe (üblicherweise ein Inverter) übertragen, wobei dieser Eingangsverstärker ein Digitalsignal erzeugt.

In der DE 42 15 444 C2 ist eine integrierte Schaltungsanordnung beschrieben, welche eine Schnittstelle zwischen einer analogen und einer digitalen Funktionseinheit aufweist, und welche ein moduliertes Analogsignal mit geringem Spannungspegel in ein (Rechteck-) Digitalsignal mit höherer Amplitude umsetzt. Zur Pegelanpassung ist ein Schaltungsteil vorgesehen, welcher zwischen Analogstufe und Digitalstufe geschaltet wird. Dieser Schaltungsteil weist ein Referenzspannungsglied zur Erzeugung einer Mittenspannung auf. Weiterhin ist ein Kondensator vorgesehen, der zwischen dem Ausgang der Analogstufe und dem Eingang der Digitalstufe, meist ein Invertereingang, angeordnet ist. Zusätzlich weist diese Pegelanpaßstufe ein hochomiges, kapazitätsarmes Verbindungsglied auf, das das Referenzspannungsglied mit dem Eingang der Digitalstufe verbindet. Das Referenzspannungsglied selbst besteht aus einem Inverter, dessen Ausgang mit dessen Eingang verbunden ist. Das Referenzspannungsglied sowie der Eingangsverstärker (Inverter) der Digitalstufe weisen jeweils zwei komplementäre MOS-Transistoren auf.

Die vorliegende Schaltung eignet sich nicht für die Umsetzung eines differenziellen Ausgangssignals einer bipolaren Differenzstufe in ein CMOS-kompatibles Eintaktsignal, da die bekannte Schaltung bereits voraussetzt, daß das Eingangssignal kein Differenzsignal, sondern nur ein einziges, auf einer Leitung geführtes Signal ist.

Die vorliegende Erfindung hat sich zur Aufgabe gemacht, eine geschwindigkeits-, eingangsempfindlichkeits- und phasenrauschoptimierte Schaltung zum Umsetzen eines differenziellen Signalpaars in ein Eintaktsignal bereitzustellen.

Erfindungsgemäß wird diese Aufgabe gelöst von einer Schaltung zur Umsetzung eines Paars aus differenziellen Signalen in ein Eintaktsignal, welche folgende Merkmale aufweist: ein Paar von Invertern, deren Eingängen das differenzielle Signalpaar zugeführt wird, wobei jeweils ein Rückkopplungs-Widerstand vorgesehen ist, der jeweils zwischen Ein- und Ausgang der Inverter geschaltet ist, einen Zweig der Schaltung, der einen Inverter mehr als ein anderer Zweig der Schaltung aufweist, ein Eintaktsignal, das an einem Verbindungsknoten abgeleitet wird, der der Ausgang eines weiteren Inverters ist, wobei die beiden Zweige jeweils einem Eingang des Inverters zugeleitet sind, und Koppelkondensatoren zum Einkoppeln des differenziellen Signalpaars in die Schaltung.

Erfindungsgemäß ist also eine Schaltung zur Umsetzung eines differenziellen Signalpaars in ein Eintaktsignal vorgesehen. Die Umsetz-Schaltung weist Koppelkondensatoren auf, die das differenzielle Signalpaar in die Umsetz-Schaltung einkoppeln (AC-Kopplung). Das erforderliche CMOS-DC-Potential wird in den in jedem Zweig ersten Invertern durch Rückkopplung erzeugt, in dem jeweils der Ein- und Ausgang der Inverter mittels eines Widerstands verbunden sind. Da das ursprüngliche Differenzsignal in einem einen Summier-Knoten bildenden, weiteren Inverter addiert wird, muß einer der beiden Zweige der Schaltung einen Inverter mehr aufweisen, als der andere Zweig. Durch die Rückkopplung der eingangsseitigen Inverter mittels Widerständen wird ein Arbeitspunkt im Punkt der maximalen Verstärkung der Inverter festgelegt.

Die Koppelkondensatoren in Serie mit den jeweiligen Rückkopplungswiderständen bilden eine Zeitkonstante. Deshalb sind die Werte der Widerstände beziehungsweise Kondensatoren so zu wählen, daß sich eine Grenzfrequenz ergibt, die es erlaubt, die Umsetz-Schaltung bei der gewünschten Frequenz betreiben zu können.

Als besonders vorteilhaft erweist sich die Generierung der Mittenspannung, bzw. des CMOS-DC-Potentials, in den signalverstärkenden Invertern selbst. Hierdurch werden Fehlspannungen, wie sie in einem Referenzinverter oder dessen Zuleitungen zum signalverstärkenden Inverter auftreten, weitestgehend vermieden. Die direkte Ansteuerung von rückgekoppelten CMOS-Verstärkern erübrigt eine bipolare Zwischenstufe zur Pegelanpassung.

Die geringe Anzahl (integrierbarer) Schaltungselemente der erfindungsgemäßen Schaltung erlaubt einen platzsparenden Schaltungsaufbau, sowie kurze Signallaufzeiten.

In einer vorteilhaften Ausführungsform der vorliegenden Erfindung bestehen die Inverter jeweils aus komplementären CMOS-Transistoren. Damit durch die Rückkopplung in den ersten Invertern auch die Arbeitspunkte der nachfolgenden Inverter im Punkt maximaler Verstärkung der Transferkenlinie eingestellt werden, ist es vorteilhaft, wenn jeweils alle verwendeten PMOS-Transistoren untereinander und alle NMOS-Transistoren untereinander jeweils gleiche Geometrien haben.

In einer weiteren vorteilhaften Ausführungsform der Erfindung wird die PMOS-Transistoren anhaftende, geringere Steilheit dadurch ausgeglichen, daß bei gleicher Kanallänge die Kanalweite der PMOS-Transistoren zwischen dem zweifachen und dreifachen Wert der Kanalweite der NMOS-Transistoren liegt.

In einer weiteren vorteilhaften Ausführungsform der Erfindung ist am Schaltungsausgang mindestens ein weiterer Inverter angeschaltet, der die Flankensteilheit des Ausgangssignals erhöht.

Weitere Einzelheiten und Ausgestaltungen der Erfindung sind in den Unteransprüchen angegeben.

Die Erfindung wird nachfolgend an mehreren Ausführungsbeispielen anhand der Zeichnungen näher erläutert.

Es zeigt:
- Figur 1: einen Schaltplan gemäß einem ersten Ausführungsbeispiel der vorliegenden Erfindung,
- Figur 2: einen Schaltplan gemäß einem zweiten Ausführungsbeispiel der vorliegenden Erfindung,
- Figur 3: einen Schaltplan gemäß einem dritten Ausführungsbeispiel der vorliegenden Erfindung.

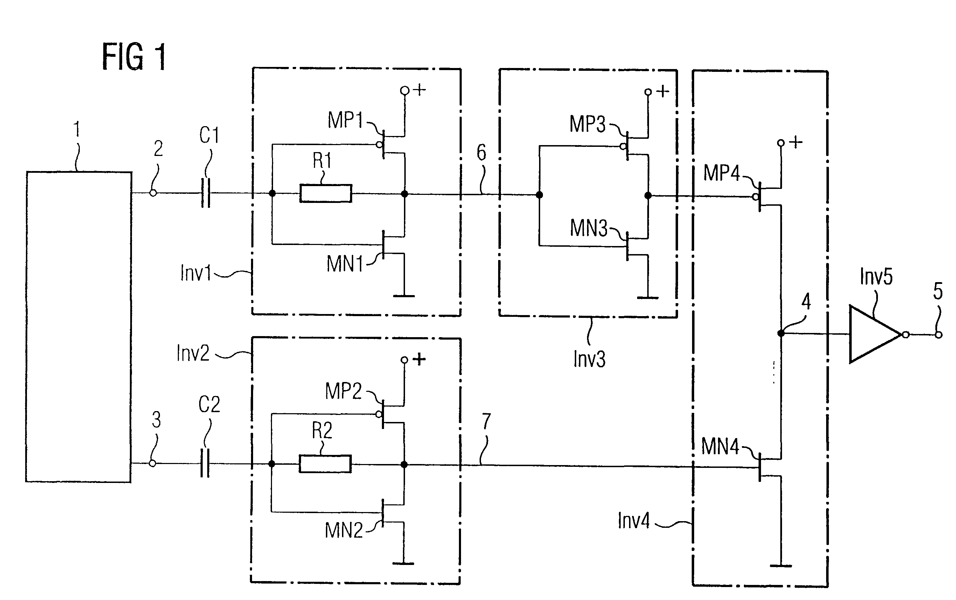

Figur 1 zeigt eine erfindungsgemäße Schaltung zur Umsetzung eines hochfrequenten analogen Differenzsignals, wie es am Ausgang einer Bipolarschaltung ansteht, in ein digitales, CMOS-kompatibles Eintaktsignal. Die erfindungsgemäße Schaltung soll beispielsweise im Versorgungsspannungsbereich von 2,7V betrieben und im Frequenzbereich um 100 Megahertz eingesetzt werden.

Das zu konvertierende Differenzsignal 2, 3 liegt typischerweise im Bereich VDD - 0,5V. Am Anschluss 3 steht das invertierte Nutzsignal des Anschlusses 2 an, beziehungsweise umgekehrt. Dieses hochfrequente Differenzsignal wird mit den Kondensatoren C1, C2 in die eigentliche Umsetz-Schaltung eingekoppelt. Das in beiden Zweigen jeweils benötigte DC-Potential zur Ansteuerung der Transistoren der Inverter wird in den jeweiligen Invertern Invl, Inv2 durch R1 beziehungsweise R2 mittels Rückkopplung generiert. Der Arbeitspunkt der Inverter Invl und Inv2 stellt sich dabei jeweils so ein, daß die Inverter im Punkt ihrer größten Verstärkung angesteuert werden. Die CMOS-Inverter selbst bestehen aus jeweils einem N-Kanal-FET und einem P-Kanal-FET. Im oberen Zweig 6 der Schaltung, die den Inverter Invl enthält, ist ein Inverter Inv3 dem Inverter Invl nachgeschaltet. Da das Signalpaar 2, 3 als Differenzsignal vorliegt, aber in einem Verbindungsknoten 4 des Inverters 4 die beiden Zweige praktisch summiert werden, muß der Zweig 6 einen Inverter mehr als der andere Zweig 7 aufweisen. Der Inverter 4 besteht ebenfalls aus zwei komplementären CMOS-Transistoren, wobei jeweils ein Gate mit jeweils einem Zweig der Schaltung, wie in Figur 1 beschrieben, verbunden ist, und stellt somit eine CMOS-Push/Pull-Stufe dar. Der Inverter Inv5 erhöht die Flankensteilheit des am Verbindungsknoten 4 anstehenden Rechteck-Eintaktsignals.

Bei der Dimensionierung von R1 und C1 beziehungsweise R2 und C2 ist darauf zu achten, daß durch die Wahl der Widerstandsbeziehungsweise Kapazitätswerte Zeitkonstanten festgelegt werden, welche eine Grenzfrequenz der Schaltung festlegen.

Das digitale Ausgangssignal der erfindungsgemäßen Schaltung ist ein sogenanntes Rail-to-Rail-Signal. Der Ausgangspegel der Schaltung bewegt sich also annähernd zwischen den Versorgungspotentialen, im vorliegenden Fall 0V und 2,7V.

Damit auch die Arbeitspunkte der den Invertern Invl und Inv2 nachgeschalteten Invertern, im vorliegenden Fall Inv3 bis Inv5 jeweils im Punkt maximaler Verstärkung liegen, ist es vorteilhaft, daß alle P-Kanal-Transistoren MP1, MP2, MP3 und MP4 untereinander gleiche Geometrien aufweisen, und ebenso die N-Kanal-MOS-Transistoren MN1, MN2, MN3 und MN4 untereinander gleiche Geometrien aufweisen. Zumindest aber sollten gleichartige Transistoren ein gleiches Kanalbreiten/Kanal-längen-Verhältnis aufweisen, um eine möglichst große Verstärkung der Schaltung zu erreichen.

Da PMOS-Transistoren üblicherweise eine geringere Steilheit als NMOS-Transistoren haben, sollte bei gleicher Kanallänge das Verhältnis der Kanalweite der PMOS-Transistoren zur Kanalweite der NMOS-Transistoren zwischen 2 und 3 liegen.

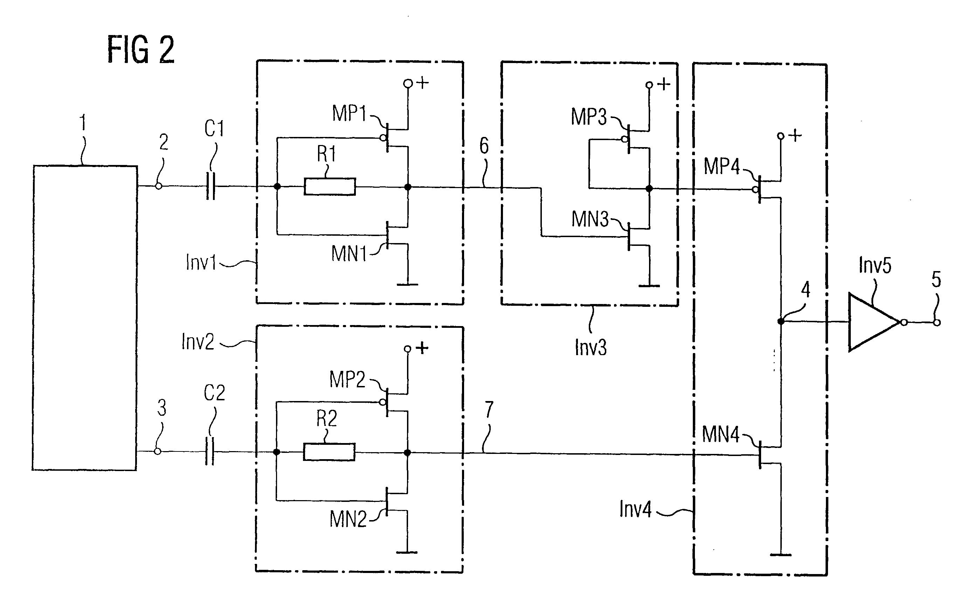

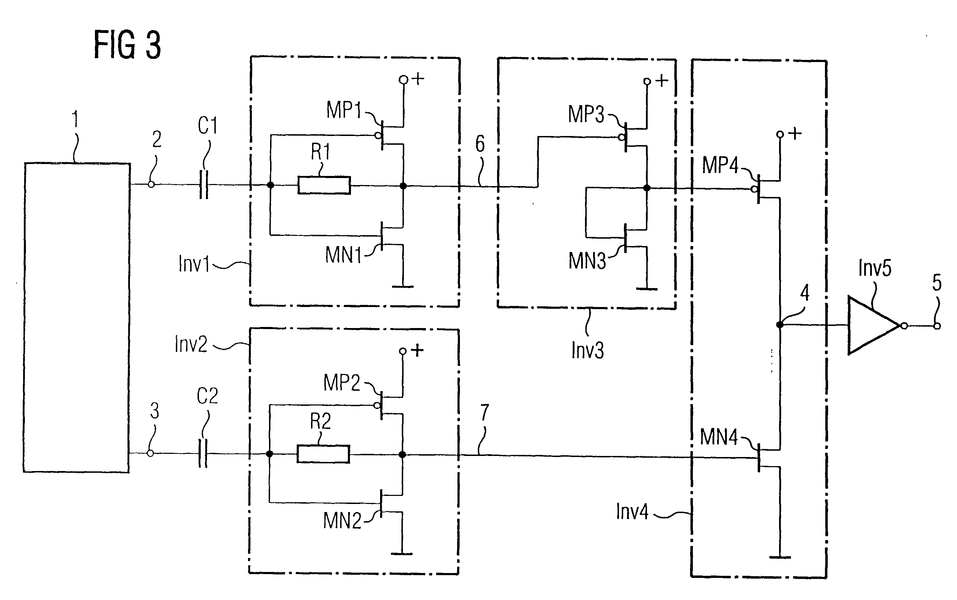

Figur 2 und 3 zeigen jeweils eine abgewandelte Realisierung des Inverters Inv3. In Figur 2 besteht der Inverter Inv3 zwar, ebenso wie in Figur 1, aus je einem PMOS- und einem NMOS-Transistor. Deren Gates sind jedoch nicht parallel geschaltet, sondern der Ausgang des Inverters Invl ist mit dem Gate des Transistors MN3 verbunden, und das Gate des Transistors MP3 ist an den Ausgang des Inverters beziehungsweise an die Drain des Transistors MP3 angeschlossen. In Figur 3 sind die Funktionen der Transistoren MP3 und MN3 vertauscht: das Gate des Transistors MP3 ist an den Ausgang des Inverters Inv1 angeschlossen, während das Gate des NMOS-Transistors MN3 an den Ausgang des Inverters Inv3 geschaltet ist.

Eine Realisierung der Schaltung ist sowohl als integrierte Schaltung, aber auch als eine aus diskreten Bauelementen bestehende Schaltung, möglich.

## Patentansprüche

1. Schaltung zur Umsetzung eines Paars aus differenziellen Signalen in ein Eintaktsignal, welche folgende Merkmale aufweist:
- ein Paar von Invertern (Inv1, Inv2), deren Eingängen das differenzielle Signalpaar (2, 3) zuführbar ist, wobei jeweils mindestens ein Rückkopplungswiderstand (R1, R2) vorgesehen ist, der jeweils zwischen Eingang und Ausgang der Inverter (Inv1, Inv2) geschaltet ist,
- einen Zweig (6), welcher einen Inverter (Inv3) mehr aufweist als ein anderer Zweig (7),
- ein Eintaktsignal (5), das einem Verbindungsknoten ableitbar ist, der der Ausgang eines weiteren Inverters (Inv4) ist, und dessen Eingängen je ein Zweig (6, 7) der Schaltung zugeleitet wird,
- Koppelkondensatoren (C1, C2) zum Einkoppeln des differenziellen Signalpaars (2, 3) in die Schaltung.

2. Schaltung nach Anspruch 1,
**dadurch gekennzeichnet**,
daß die Inverter (Invl, Inv2, Inv3, Inv4, Inv5) aus jeweils einem PMOS- und einem NMOS-Transistor bestehen,

3. Schaltung nach Anspruch 2,
**dadurch gekennzeichnet**,
daß jeweils alle PMOS-Transistoren untereinander gleiche Geometrien haben und alle NMOS-Transistoren untereinander gleiche Geometrien haben.

4. Schaltung nach Anspruch 2,
**dadurch gekennzeichnet**,
daß jeweils alle PMOS-Transistoren untereinander gleiche Kanalweiten/Kanallängen-Verhältnisse aufweisen und alle NMOS-Transistoren ebenfalls untereinander gleiche Kanalweiten/Kanallängen-Verhältnisse aufweisen.

5. Schaltung nach Anspruch 2,
**dadurch gekennzeichnet**,
daß das Verhältnis der Kanalweite von PMOS-Transistoren zur Kanalweite der NMOS-Transistoren bei jeweils gleicher Kanallänge zwischen 2 und 3 liegt.

6. Schaltung nach Anspruch 1,
**dadurch gekennzeichnet**,
daß mindestens ein Inverter (Inv3) einen PMOS- und einen NMOS-Transistor aufweist, wobei das Gate eines der beiden Transistoren mit dem Ausgang des Inverters, und das Gate des jeweils anderen Transistors mit dem Eingang des Inverters verbunden ist.
